# EUROPEAN PATENT SPECIFICATION

(11) **EP 2 830 214 B1**
(45) Date of publication and mention of the grant of the patent: **21.11.2018**
(21) Application number: 14176819.2
(22) Date of filing: 11.07.2014
(51) Int. Cl.: H03F 3/45, H03K 5/08, H04L 25/06, H04L 25/49

(54) **PVT tolerant differential circuit**
PVT-tolerante Differenzialschaltung
Circuit différentiel tolérant PVT

(30) Priority: 11.07.2013 US 201361845120 P; 16.04.2014 US 201414254813
(43) Date of publication of application: 28.01.2015
(73) Proprietor: Samsung Display Co., Ltd., Gyeonggi-do (KR)
(72) Inventor: Hekmat, Mohammad, San Jose, CA 95112 (US); Amirkhany, Amir, San Jose, CA 95112 (US)
(74) Representative: Mounteney, Simon James

(56) References cited:
- US-A1- 2005 151 588
- US-A1- 2009 039 958
- US-A1- 2009 189 694
- US-A1- 2011 115 561

## Description

### BACKGROUND

### 1. Field

Aspects of the present invention relate to a process, voltage, and temperature (PVT) tolerant differential circuit and a comparator including the PVT tolerant differential circuit.

### 2. Description of Related Art

A differential circuit (or differential amplifier) is a kind of electronic circuit that amplifies the difference between two input signals. A common configuration of a differential circuit is a differential pair, which includes two amplifying stages with common degeneration.

Many electronic devices use differential circuits. For example, a comparator, which is a device that compares two input signals and outputs a signal based on this comparison, may use a differential circuit. In one configuration, a comparator receives two input signals and outputs a signal indicating which of the received signals is larger. In another configuration, a comparator receives two signals (e.g., two complementary signals) and outputs a signal indicating whether or not the difference between the two received signals is greater than a detection level.

A comparator implemented to perform the above-described level detection has numerous applications, including multilevel serial/parallel links, analog-to-digital converters, and peak detection. Mismatched differential circuits (e.g., circuits with mismatched amplifier stages) may be used in a comparator to set the offset voltage adjustment and for level detection. Enabling a wide range of detection levels is desirable to extend the usable range of a comparator circuit (e.g., to increase the detection range).

Additionally, it is desirable to have differential circuits which are resilient to environmental or process variations. For example, in multilevel systems, the various detection level voltages should, ideally, remain constant under process, voltage, and temperature (PVT) variations; otherwise the system may fail, may be error prone, or may require over-designing to accommodate the variations. As described above, the detection level voltages may be set using mismatched differential circuits; however, the detection levels of mismatched differential circuits are a function of the overdrive of the mismatched differential circuits, which may vary across PVT conditions. US 2011/0115561 discloses a differential amplifier configured to stabilize a common mode output voltage from the amplifier in response to changes in the common mode input voltage. US2009/189694 discloses an amplifier with an accurate input offset voltage.US 2009/039958 discloses an operational amplifier with an extended common mode input range. US 2009/151588 discloses a variable gain amplifier with improved power supply rejection.

### SUMMARY

According to a first aspect there is provided a differential amplifier according to claim 1. According to a second aspect, there is provided a multilevel signal receiver according to claim 7. Details of embodiments are provided in the dependent claims. Further insight into the disclosure is provided by the following embodiments and examples. Aspects of the present invention are directed toward providing a mismatched differential circuit that remains resilient to process and environmental variations. For example, aspects of the present invention provide a process, voltage, and temperature (PVT) tolerant differential circuit. Differential circuits according to embodiments of the present invention may be used in comparators and multilevel receivers, as examples.

In an aspect, there is provided an automatically calibrated differential amplifier for use as a comparator in a multilevel signal receiver. The differential amplifier comprises an input stage differential amplifier configured to receive an input differential signal, to differentially amplify the input differential signal to generate an input stage output differential signal and to have an input stage bias current. The amplifier further comprises a replica stage differential amplifier comprising a first amplifier leg and a second amplifier leg and a feedback circuit. The first and second amplifier legs, together, are configured to receive a reference differential signal and differentially amplify the reference differential signal to provide a replica stage output differential signal. The feedback circuit is configured to receive a differential output of the replica stage differential amplifier, output a reference current (It) based on the replica stage output differential signal; and copy the reference current to the input stage differential amplifier to enable automatic calibration. A sum of a first amplifier leg current of the first amplifier leg and a second amplifier leg current of the second amplifier leg equals the replica stage bias current, and the replica stage bias current and the input stage bias current are based on the reference current.

In an embodiment, he feedback circuit includes a comparator and a current generator, and the comparator is configured to receive the replica stage output differential signal and to control the current generator to increment or decrement the reference current according to the replica stage output differential signal.

In an embodiment,the feedback circuit includes an amplifier and a transistor, the transistor being configured to output the reference current, and the amplifier is configured to receive the replica stage output differential signal and to control a gate voltage of the transistor according to the replica stage output differential signal to adjust the reference current.

In an embodiment, the replica stage differential amplifier further includes: a first resistor having a first terminal coupled to a voltage source, and a second terminal; a second resistor having a first terminal coupled to the voltage source, and a second terminal; a first current sink configured to sink a first current; a second current sink configured to sink a second current; a first transistor having a first terminal coupled to the second terminal of the first resistor, a second terminal coupled to the first current sink, and a gate terminal configured to receive a first reference signal of the reference differential signal; a second transistor having a first terminal coupled to the second terminal of the second resistor, a second terminal coupled to the first current sink, and a gate terminal configured to receive a second reference signal of the reference differential signal; a third transistor having a first terminal coupled to the second terminal of the second resistor, a second terminal coupled to the second current sink, and a gate terminal configured to receive the second reference signal of the reference differential signal; a fourth transistor having a first terminal coupled to the second terminal of the first resistor, a second terminal coupled to the second current sink, and a gate terminal configured to receive the first reference signal of the reference differential signal; and a feedback circuit configured to receive the replica stage output differential signal from the first terminal of the first transistor and the first terminal of the second transistor, and to output the reference current. Here, the first current and the second current is based on the reference current, and a sum of the first current and the second current equals the replica stage bias current.

In an embodiment, the automatically calibrated differential amplifier further includes a current mirror coupled to the input stage differential amplifier and the replica stage differential amplifier. Here, the current mirror copies the reference current to control the input stage bias current.

In an embodiment, the input stage differential amplifier includes a first amplifier leg including a first transistor and a second amplifier leg including a second transistor, and is configured to be at an input stage of a comparator. Here, the first and second amplifier legs of the input stage differential amplifier, together, are configured to differentially amplify the differential input signal, the input stage differential amplifier is configured to have an input offset voltage, and the input offset voltage corresponds to a difference between a bulk potential of the first transistor and a bulk potential of the second transistor.

According to an aspect of the present invention, there is provided a multilevel signal receiver including: an input terminal configured to receive a multilevel differential signal; a data slicer coupled to the input terminal and configured to determine voltage levels of the multilevel differential signal, the data slicer including a plurality of input stage comparators and a replica stage comparator; and a decoder coupled to an output of the data slicer and configured to decode bits of the multilevel differential signal. Here, each of the input stage comparators includes an input stage differential amplifier, the input stage differential amplifier including: a first amplifier leg; and a second amplifier leg, the first amplifier leg and the second amplifier leg, together, are configured to differentially amplify the multilevel differential signal to provide a threshold determination signal, the input stage differential amplifier is configured to have an input offset voltage and an input stage bias current, and each of the input stage comparators is configured to have a threshold level different from the threshold level of other ones of the input comparators. Also, each of the input stage comparators is configured to output its threshold determination signal to the decoder to indicate whether or not the multilevel signal is greater than its threshold level, for each of the input stage comparators, the threshold level corresponds to the input offset voltage of the input stage differential amplifier. The replica stage comparator includes a replica stage differential amplifier, the differential amplifier including: a first amplifier leg; a second amplifier leg; and a feedback circuit configured to automatically adjust a replica stage bias current according to a replica stage differential output signal. For each of the input stage comparators, the input stage bias current of the input stage differential amplifier is based on the replica stage bias current.

In an embodiment, he replica stage differential amplifier is configured to: receive a reference differential signal; differentially amplify the reference differential signal to provide the replica stage output differential signal; and provide a reference current based on the replica stage output differential signal. The replica stage bias current and the input stage bias current is based on the reference current.

In an embodiment, the feedback circuit is coupled to the first amplifier leg and the second amplifier leg of the replica stage differential amplifier, and configured to output the reference current, the first amplifier leg and the second amplifier leg of the replica stage differential amplifier, together, are configured to differentially amplify the reference differential signal to provide the replica stage output differential signal, the feedback circuit receives the replica stage output differential signal and outputs the reference current according to the replica stage output differential signal, and a sum of a first amplifier leg current of the first amplifier leg and a second amplifier leg current of the second amplifier leg equals the replica stage bias current.

In an embodiment,the feedback circuit includes a comparator and a current generator. The comparator is configured to receive the replica stage output differential signal and to control the current generator to increment or decrement the reference current according to the replica stage output differential signal.

In an embodiment, the feedback circuit includes an amplifier and a transistor, the transistor being configured to output the reference current. The amplifier is configured to receive the replica stage output differential signal and to control a gate voltage of the transistor according to the replica stage output differential signal to adjust the reference current.

In an embodiment, the multilevel signal receiver further includes a current mirror coupled to the input stage differential amplifier of each of the input stage comparators and the replica stage differential amplifier. The current mirror copies the reference current to control the input stage bias current of the input stage differential amplifier of each of the input stage comparators.

In an embodiment, the replica stage differential amplifier further includes: a first resistor having a first terminal coupled to a voltage source, and a second terminal; a second resistor having a first terminal coupled to the voltage source, and a second terminal; a first current sink configured to sink a first current; a second current sink configured to sink a second current; a first transistor having a first terminal coupled to the second terminal of the first resistor, a second terminal coupled to the first current sink, and a gate terminal configured to receive a first reference signal of the reference differential signal; a second transistor having a first terminal coupled to the second terminal of the second resistor, a second terminal coupled to the first current sink, and a gate terminal configured to receive a second reference signal of the reference differential signal; a third transistor having a first terminal coupled to the second terminal of the second resistor, a second terminal coupled to the second current sink, and a gate terminal configured to receive the second reference signal of the reference differential signal; a fourth transistor having a first terminal coupled to the second terminal of the first resistor, a second terminal coupled to the second current sink, and a gate terminal configured to receive the first reference signal of the reference differential signal; and a feedback circuit configured to receive the replica stage output differential signal from the first terminal of the first transistor and the first terminal of the second transistor, and to output the reference current. Here, the first current and the second current is based on the reference current, and a sum of the first current and the second current equals the replica stage bias current.

The input offset voltage of the input stage differential amplifier of at least one of the input stage comparators may correspond to a difference between a bulk potential of the first transistor and a bulk potential of the second transistor.

At least some of the above and other features of the invention are set out in the claims.

### BRIEF DESCRIPTION OF THE DRAWINGS

The accompanying drawings illustrate embodiments of the present invention, and, together with the description, serve to explain features and aspects of the present invention.
FIG. 1 illustrates a multilevel receiver according to an embodiment of the present invention.
FIG. 2 illustrates a mismatched differential circuit according to an embodiment of the present invention.
FIG. 3 depicts graphs illustrating the I-V characteristics of three differential circuits according to embodiments of the present invention.
FIG. 4 depicts a graph illustrating the impact of PVT variations on the offset voltage of a differential circuit device.
FIG. 5 illustrates a replica stage differential circuit according to an embodiment of the present invention.
FIG. 6 depicts a graph illustrating the resiliency against the impact of PVT variations on the offset voltage of a differential circuit device according to an embodiment of the present invention.
FIG. 7 illustrates a replica stage differential circuit according to another embodiment of the present invention.
FIG. 8 is a block diagram of a digital communication link for a display according to an embodiment of the present invention.

### DETAILED DESCRIPTION

Aspects of the present invention are directed toward providing a differential circuit that remains resilient to process and environmental variations.

Differential circuits according to embodiments of the present invention may be implemented as mismatched differential circuits, which may be included in comparators. For example, a mismatched differential circuit may be used to set a comparator's detection level. A mismatched differential circuit may be implemented as a differential amplifier pair (commonly referred to as a "differential pair"), where the two amplifying stages (or legs) with common (emitter, source, cathode, etc.) degeneration have different (or mismatched) properties. This property mismatch creates an inherent offset in the amplifying stages. Accordingly, by changing the property mismatch, the offset changes; thus, the comparator's detection level may be adjusted.

A comparator's detection level is also a function of an overdrive voltage of its input device, which varies according to the threshold voltage of the input device (e.g., a transistor). Specifically, the overdrive voltage may be defined by the equation, V_{OV} = V_{GS} - Vₜ. Where V_{OV} is the overdrive voltage of the input device, V_{GS} is the gate-to-source voltage of the input device, and Vₜ is the threshold voltage of the device.

The device's threshold voltage may fluctuate according to process and environmental (e.g., voltage and temperature) variations; accordingly, the comparator's detection level may fluctuate in-turn according to process and environmental variations. A fluctuating detection level, however, may significantly hamper performance of the comparator. For example, the fluctuating detection level may cause detection errors. One way to compensate for this detection level fluctuation is to overdesign the system to account for the fluctuation. However, this may create undesirable design or power overhead.

Accordingly, aspects of the present invention automatically calibrate the differential circuit to maintain the comparator's detection level regardless of process, voltage, or temperature (PVT) variations. According to an embodiment, the detection level of comparator is maintained through a feedback loop that adjusts the bias current of the differential circuit to compensate for PVT variation.

For example, the feedback loop employs a replica stage differential circuit and a reference voltage to adjust the bias current of the differential circuit to compensate for PVT variation. The reference voltage is applied to the input of the replica stage differential circuit under a known operating condition (e.g., a maximum detection setting). The outputs of the replica stage differential circuit is received by an amplifier (e.g., an analog amplifier) or a comparator (e.g., a digital comparator) that controls the bias current to force the outputs of the replica stage differential circuit to be at the same voltage for the given reference voltage at its input. The replica stage bias current is replicated to the differential circuit.

Accordingly, the feedback loop maintains the detection level of the comparator under a variety of temperature and voltage conditions or under a variety of process corners. The above-described calibration together with a constant swing load keeps the threshold voltage, as well as an effective gain, of a differential circuit device constant across a PVT range. According to an aspect of the present invention, calibration at a single detection level is sufficient to guarantee tracking across all points because the threshold value has a mild nonlinear dependence on the bias current.

According to an embodiment of the present invention, there is provided a multilevel receiver including a plurality of comparators each having different detection levels and each including a differential circuit. The multilevel receiver further includes a replica stage differential circuit to calibrate the other differential circuits such that they are PVT tolerant. To this end, the replica stage differential circuit controls the bias current of the other differential circuits to compensate for PVT variations.

Hereinafter, certain embodiments of the present invention are shown and described by way of illustration. As those skilled in the art would recognize, the invention may be embodied in many different forms and should not be construed as being limited to the embodiments set forth herein. Instead, the detailed description should be construed to encompass the scope of the appended claims and equivalents thereof. Also, in the present application, when an element is referred to as being "coupled" (e.g., electrically coupled or connected) to another element, it may be directly coupled to the other element or indirectly coupled to the other element with one or more intervening elements interposed therebetween. Hereinafter, like reference numerals refer to like elements.

Expressions, such as "at least one of," when preceding a list of elements, modify the entire list of elements and do not modify the individual elements of the list. Further, the use of "may" when describing embodiments of the present invention refers to "one or more embodiments of the present invention."

The following example embodiments are described in the context of a multilevel data system for ease of explanation. A person of ordinary skill in the art would recognize, however, that the scope of the present invention is not limited thereto.

Multilevel data systems quantize data into more than two levels, thereby using less channel bandwidth than the same capacity binary data system. One such multilevel data system is a PAM-4 (pulse amplitude modulation - 4 levels) data system. A PAM-4 data system may include a transmitter, a transmission link, and a receiver. The PAM-4 transmitter encodes a pair of bits into a four-level signal, for example, V₁, V₂, V₃, and V₄ (e.g., -0.66V, -0.33V, 0.33V, and 0.66V) and sends the encoded multilevel signal over the transmission link to the PAM-4 receiver. The PAM-4 receiver reconstructs the transmitted multilevel signal by comparing the received signal to three different detection level voltages, V_{R1}, V_{R2}, and V_{R3}.

In one embodiment of a PAM-4 receiver, the detection level voltages are determined according to the following logic: V₁ < V_{R1} < V₂ < V_{R2} < V₃ < V_{R3} < V₄. For example, where the four levels of the multilevel signal are -0.66V, -0.33V, 0.33V, and 0.66V, the detection level voltages may be -0.5V, 0V, and 0.5V (e.g., a differential configuration). In another example, where the four levels of the multilevel signal are 0V, 0.33V, 0.66V, and 1V, the detection level voltages may be 0.25V, 0.5V, and 0.75V (e.g., a single ended configuration).

Here, if the received multilevel signal is less than V_{R1}, then the receiver determines that the multilevel signal is transmitting the logic level associated with V₁ (e.g., 00). If the received multilevel signal is greater than V_{R1}, but less than V_{R2}, then the receiver determines that the multilevel signal is transmitting the logic level associated with V₂ (e.g., 01). If the received multilevel signal is greater than V_{R2}, but less than V_{R3}, then the receiver determines that the multilevel signal is transmitting the logic level associated with V₃ (e.g., 10). And, if the received multilevel signal is greater than V_{R2}, then the receiver determines that the multilevel signal is transmitting the logic level associated with V₄ (e.g., 11).

In an implementation of a PAM-4 receiver, the multilevel signal is reconstructed by using three comparators, each having a different detection level, and a decoder.

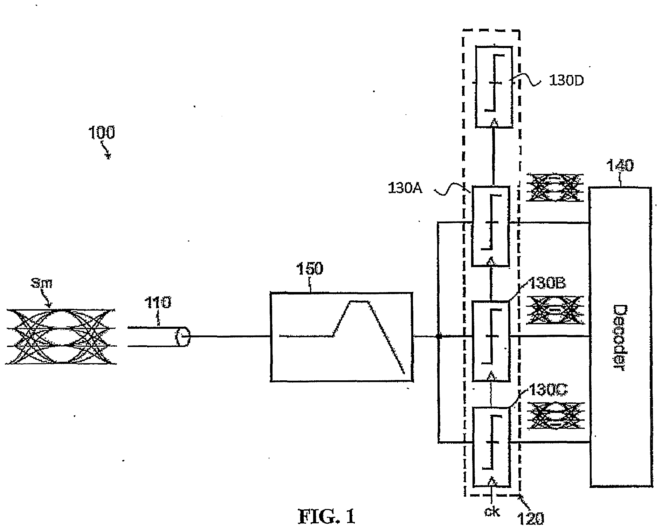

FIG. 1 illustrates a multilevel receiver according to an embodiment of the present invention.

According to an embodiment of the present invention, a pulse amplitude modulation (PAM) receiver 100 includes a transmission link 110 for receiving the multilevel data signal Sₘ (which encodes more than one bit of data), a data slicer 120 that includes a plurality of comparators 130, and a decoder 140. The PAM receiver may also include a pre-amplifier 150 to provide gain level shifting and equalization to the multilevel data signal Sₘ before it reaches the data slicer 120. According to an embodiment of the present invention, the multilevel data signal Sₘ is a differential signal.

In accordance with one aspect of the present invention, a data slicer 120 includes a first comparator 130A that establishes a first detection level voltage V_{R1}, a second comparator 130B that establishes a second detection level voltage V_{R2}, and a third comparator 130C that establishes a third detection level voltage V_{R3}. As described above, the second detection level voltage V_{R2} may be greater than the first detection level voltage V_{R1} and less than the third detection level voltage V_{R3}.

In accordance with another aspect of the present invention, the data slicer 120 includes a replica stage (or dummy) comparator 130D. The replica stage comparator 130D automatically calibrates the comparators 130A, 130B, and 130C to maintain their detection levels despite variations in process, voltage, and temperature (PVT). A detailed description of the replica stage comparator 130D is given below.

Referring now to the comparators, 130A, 130B, and 130C, the comparators 130A, 130B, and 130C establish three detection levels to provide four distinct outputs depending on the relationship of the multilevel data signal Sₘ to the three detection levels. Accordingly, the inputs of the comparators 130A, 130B, and 130C are coupled together to form a common differential input terminal to receive the multilevel data signal Sₘ.

Also, each of the comparators 130A, 130B, and 130C has a differential output terminal coupled to the decoder 140. The decoder 140 receives each of the comparators' 130A, 130B, and 130C differential output signal (e.g., a level determination signal) from their respective differential output terminal, and decodes the data transmitted via the multilevel data signal Sₘ based on the received differential output signals.

As mentioned above, the comparators 130A, 130B, and 130C collectively provide four distinct outputs to the decoder. Each of these outputs corresponds to a particular one of the four signal levels of generated by a PAM-4 transmitter, which encodes two bits of data. Accordingly, the decoder can decode the two bits of data transmitted by the PAM-4 multilevel data signal Sₘ.

According to an aspect of the present invention, the detection levels of the comparators 130A, 130B, and 130C are controlled using mismatched differential circuits.

For example, the first comparator 130A may include a first mismatched differential circuit that has a first offset voltage Vₒₛ₁ to enable the first detection level voltage V_{R1}, the second comparator 130B may include a second mismatched differential circuit that has a second offset voltage Vₒₛ₂ to enable the second detection level voltage V_{R2}, and the third comparator 130C may include a third mismatched differential circuit that has a third offset voltage Vₒₛ₃ to enable the third detection level voltage V_{R3}.

According to one embodiment of the present invention, each of the mismatched differential circuits included in the respective comparator 130A, 130B, or 130C has a different offset voltage Vₒₛ from the other ones in order to provide the three different detection levels.

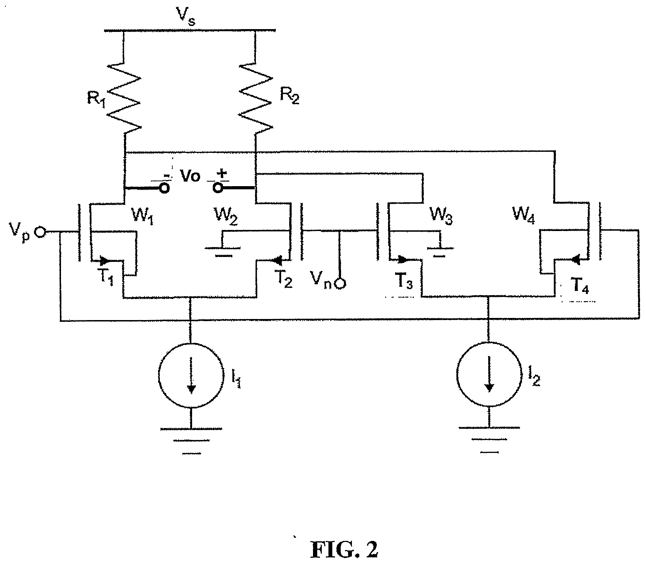

Referring now to FIG. 2, which illustrates a mismatched differential circuit according to an embodiment of the present invention.

The mismatched differential circuit 10 of FIG. 2 illustrates an embodiment of the present invention that provides a triple-mismatched differential pair. That is, the mismatched differential circuit 10 illustrates a differential amplifier circuit that may have property mismatches in device bulk potential, device size, and bias current. A person of ordinary skill in the art would recognize that the present invention is not restricted to triple-mismatched differential circuits, but instead, may use any of a variety of differential circuits.

The mismatched differential circuit 10 according to the present embodiment includes two differential amplifier pairs.

Specifically, the mismatched differential circuit 10 of FIG. 2 includes first through fourth transistors T₁ through T₄, where each transistor corresponds to one amplifier stage of one of the two amplifier pairs. Here, the first transistor T₁ and the second transistor T₂ have their sources commonly coupled to a first current sink I₁ and are coupled to a voltage source Vₛ through respective resistors R₁ and R₂. The first and second transistors T₁ and T₂ correspond to the first differential amplifier pair. The third transistor T₃ and the fourth transistor T₄ similarly have their sources commonly coupled to a second current sink I₂ and are coupled to the voltage source Vₛ through respective resistors R₁ and R₂. The third and fourth transistors T₃ and T₄ correspond to the second differential amplifier pair.

The first and second differential amplifier pairs are coupled together to effectively operate as a single differential amplifier pair. That is, the first and second differential pairs collectively receive the same differential input signal and operate together to produce a single differential output signal.

A feature of using the two coupled differential amplifier pairs is that the different current sinks may be mismatched so as to provide additional offset voltage range. For example, the value of the current of the first current sink I₁ may be set to be larger than the value of the current of the second current sink I₂, which creates an asymmetric amplifying leg resulting in the sought after control of the offset voltage.

Another feature of using the two coupled differential amplifier pairs is that there are more device parameters available to adjust, which expands offset voltage flexibility. For example, the bulk potentials and/or sizes (e.g., widths W₁ through W₄) of the transistors may be mismatched so as to enable further flexibility in the available offset voltage.

Bulk potentials may be mismatched either statically or dynamically. Static bulk potential mismatch may be achieved by directly connecting the bulk of a transistor to its source, a ground potential, or a static voltage source. Dynamic bulk potential mismatch may be achieved by connection the bulk of a transistor to a variable voltage source or by enabling the dynamic connection of the bulk to various nodes (e.g., ground, voltage source, or device source).

The differential circuit further includes two input nodes to receive a complementary pair of input signals Vₚ and Vₙ, respectively, and two output nodes to output the complementary pair of output signals Vₒ₊ and Vₒ₋, respectively. In the present embodiment, the two input nodes are at the gates of the transistors T₁ thru T₄, and the output nodes are at the drains of the transistors T₁ thru T₄.

The complementary pair of input signals Vₚ and Vₙ (together, the differential input signal) are differentially amplified (i.e., subtracted and multiplied) by the differential pair to generate the complementary pair of output signals Vₒ₊ and Vₒ₋ (together, the differential output signal).

Due to the mismatch in the amplifier pairs, the differential amplification is asymmetrical as to the different inputs. This asymmetry introduces the offset voltage, described above, and results in establishing the detection level for a comparator.

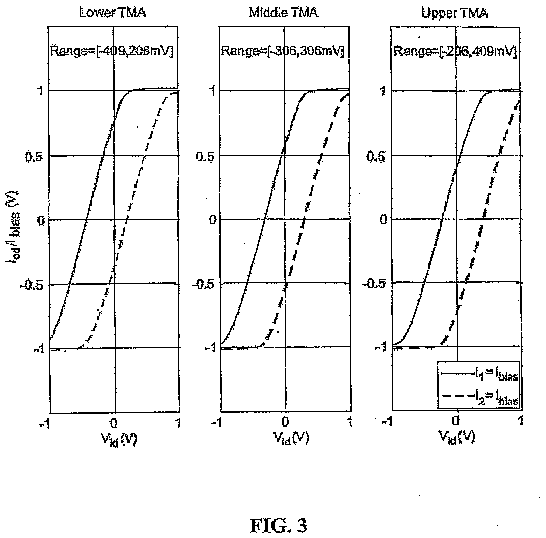

Examples of achievable offset voltage ranges are illustrated in FIG. 3. FIG. 3 shows graphs illustrating the I-V characteristics of differential circuits according to embodiments of the present invention.

FIG. 3 illustrates I-V characteristic ranges for three differential circuits. These three I-V characteristic graphs may correspond to the three differential circuits for comparators 130A, 130B, and 130C described above in connection with FIG. 1. As illustrated in these graphs, the three mismatched differential circuits are configurable to provide a lower, middle, and upper set of offset voltage ranges to correspond to the lower, middle, and upper detection levels of comparators used in a multilevel receiver.

According to one embodiment, the lower and upper mismatched differential circuits are triple-mismatched differential circuits, which are configurable to have bulk potential, device size, and bias current mismatches. The lower and upper mismatched differential circuits may be mirrors of each other. That is, amplifier legs in the lower mismatched differential circuit may have a particular mismatch of circuit properties and the amplifier legs in the upper mismatched differential circuit may have a corresponding, but reversed, mismatch of circuit properties (e.g., reversed as to which leg has which circuit properties).

For example, referring back to FIG. 2, the lower mismatched differential circuit may be configured such that the first and fourth transistors T₁ and T₄ have a bulk-to-source connection, the second and third T₂ and T₃ transistors have a bulk-to-ground connection, and the first and third transistors' widths W₁ and W₃ are the same size and greater than the second and fourth transistors' widths W₂ and W₄ (which are the same size). This configuration results in a first offset voltage Vₒₛ₁. For example, in an embodiment where the first and third widths W₁ and W₃ are about 4.8µm and the second and fourth widths W₂ and W₄ are about 1.2µm, the first offset voltage Vₒₛ₁ may be about -203mV.

By configuring the upper mismatched differential circuit in a corresponding, but opposite fashion to the lower mismatched differential circuit, it may have a third offset voltage Vₒₛ₃ that is the same magnitude but opposite in polarity as the first offset voltage Vₒₛ₁. For example, the upper mismatched differential circuit may be configured such that the first and fourth transistors T₁ and T₄ have a bulk-to-ground connection, the second and third T₂ and T₃ transistors have a bulk-to-source connection, and the first and third transistors' widths W₁ and W₃ are the same size and less than the second and fourth transistors' widths W₂ and W₄ (which are the same size). In an embodiment where the first and third widths W₁ and W₃ are about 1.2µm and the second and fourth widths W₂ and W₄ are about 4.8µm, the third offset voltage Vₒₛ₃ may be about +203mV.

Accordingly, with this mirrored mismatch configuration, the lower and upper mismatched differential circuits may have offset voltages of the same magnitude, but with different polarity.

Also, according to one embodiment, the middle differential circuit may be configured such that its device properties are matched (i.e., that it is balanced) so that its offset voltage Vₒₛ₂ is at 0V.

Furthermore, as described above, these differential circuits are configurable to have a triple-mismatch by adjusting a bias current. For example, referring back to FIG. 2, the current sinks I₁ and I₂ (collectively, setting the bias current) may be mismatched to further extend the offset voltage range. This may be implemented dynamically or statically. The I-V graphs of FIG. 3 illustrate an embodiment of this scenario.

In FIG. 3, the x-axis represents a differential input voltage and the y-axis represents a differential output current for the differential circuits. In each of the graphs, the solid line represents a configuration where the bias current is wholly supplied by the first current sink I₁ and the dashed line represents a configuration where the bias current is wholly supplied by the second current sink I₂. The area between these two lines are within the operable range of the mismatched differential circuits, and are achieved by adjusting the mismatch of the first and second current sinks I₁ and I₂. According to one embodiment the bias current is variable according the following expression: bias current = I₁ + I₂.

In one embodiment, the offset voltage ranges are centered on the offset voltage for the configuration where the bias current is balanced between the first and second current sinks I₁ and I₂. As such, the center of the offset voltage ranges correspond to the above-description of the first and third offset voltages Vₒₛ₁ and Vₒₛ₃ respectively corresponding to the mirrored lower and upper mismatched differential circuits and the second offset voltage Vₒₛ₂ corresponding to the balanced middle differential circuit.

According to one embodiment, the bias current is about 400µA. Therefore, the value of the currents of the first and second current sinks I₁ and I₂ add up to 400 µA. Here, the magnitude of the offset voltage range may be about 600mV.

Accordingly, an embodiment of the lower mismatched differential circuit may have an offset voltage centered at about -203mV and a range of about -409mV to about 206mV, an embodiment of the middle mismatched differential circuit may have an offset voltage centered at about 0V and a range of about -306mV to about 306mV, and an embodiment of the upper mismatched differential circuit may have an offset voltage centered at about 203mV and a range of about -206mV to about 409mV.

As such, when configuring comparators having mismatched differential circuits according to embodiments of the present invention for use in a multilevel signal receiver, a wide range of detection levels are available.

Referring back to FIG. 1, according to one embodiment of the present invention, each of the comparators 130A, 130B, and 130C includes a circuit corresponding to the differential circuit 10 described above in connection with FIG. 2. Here, each of the differential circuits 10 included with the respective comparator 130A, 130B, or 130C has a different offset voltage Vₒₛ from the other ones in order to provide the three different detection levels.

For example, the first comparator 130A may include a width mismatched differential circuit to provide the first detection level voltage V_{R1}, the second comparator 130B may include a bulk mismatched differential circuit to provide the second detection level voltage V_{R2}, and the third comparator may include a width and bulk mismatched differential circuit to provide the third detection level voltage V_{R3}.

As described above, the detection level voltage of a particular comparator is based on the offset voltage of its differential circuit. The offset voltage of a differential circuit is further based on the overdrive voltage of an input device (e.g., a transistor in an amplifier leg) in the differential circuit. Specifically, the overdrive voltage may be defined by the equation, V_{OV} = V_{GS} - Vₜ. Where V_{OV} is the overdrive voltage of the input device, V_{GS} is the gate-to-source voltage of the input device, and Vₜ is the threshold voltage of the device.

The input device's threshold voltage may fluctuate according to process, voltage, and temperature (PVT) variations. Accordingly, the comparator's detection level may fluctuate in-turn according to PVT variations. By way of examples, process variations include variations in the device as a result of manufacturing, which may include differences between chips and within chips; voltage variations may include variations due to different supply voltages, noise, or resistive voltage drop; and temperature variations may include ambient, chip, or local temperature variations.

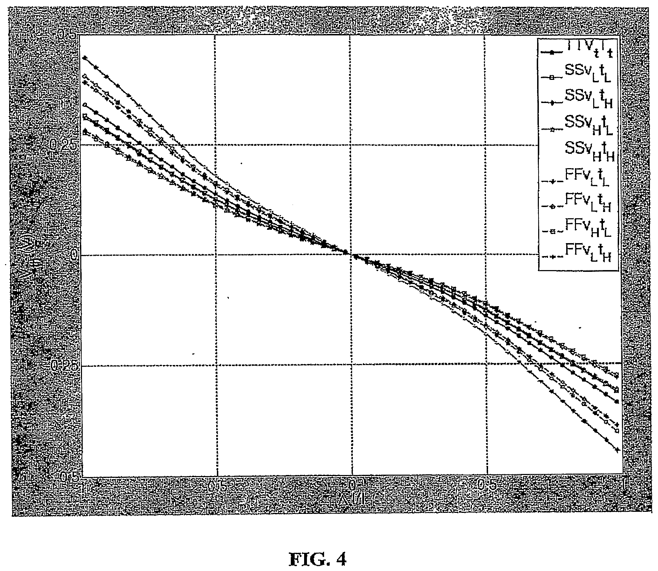

Referring now to FIG. 4, FIG. 4 depicts a graph illustrating the impact of PVT variations on the offset voltage a differential circuit device.

FIG. 4 illustrates nine (9) waveforms to show the impact that PVT variations may have on the offset voltage of an uncompensated differential circuit device. In this example, it can be assumed that the waveforms correspond to the mismatched differential circuit illustrated in FIG. 2 under various process and environmental conditions. Further, it can be assumed that the first current sink I₁ sinks a current according to the equation I + ΔI; and the second current sink I₂ sinks a current according to the equation I - ΔI.

In FIG. 4, the x-axis shows the ratio of current mismatch to the total bias current.. Specifically, the x-axis corresponds to ΔI/I. Additionally, the y-axis corresponds to the offset voltage of the differential circuit.

Each of the nine (9) waveforms has the following naming convention: NPV_{X}T_{X}. Where, N corresponds to an N-type transistor, which may be designated T, S, or F; T designating a typical device, S designating a slow device, and F designating a fast device. Where P corresponds to a P-type transistor, which may be designated T, S, or F; T, S, and F having similar meanings as above. The designations for N and P are used to signify process variations. V is used to signify voltage variations, which may be designated as T, L, or H; T designating a typical voltage, L designating a low voltage, and H designating a high voltage. The final T is used to signify temperature variations, which may be designated as T, L, or H; T designating a typical temperature, L designating a low temperature, and H designating a high temperature.

The first waveform TTV_{T}T_{T} illustrates the typical (or average) process and operating conditions and is shown with a solid black line with circles. The second waveform SSV_{L}T_{L} illustrates a slow device with low temperature and voltage operating conditions, and is shown with a solid black line with squares. The third waveform SSV_{L}T_{H} illustrates a slow device with low voltage and high temperature operating conditions, and is shown with a solid black line with diamonds. The fourth waveform SSV_{H}T_{L} illustrates a slow device with high voltage and low temperature operating conditions, and is shown with a solid grey line with circles. The fifth waveform SSV_{H}T_{H} illustrates a slow device with high temperature and voltage operating conditions, and is shown with a solid grey line with diamonds. The sixth waveform FFV_{L}T_{L} illustrates a fast device with low temperature and voltage operating conditions, and is shown with a broken black line with diamonds. The seventh waveform FFV_{L}T_{H} illustrates a fast device with low voltage and high temperature operating conditions, and is shown with a broken black line with circles. The eighth waveform FFV_{H}T_{L} illustrates a fast device with high voltage and low temperature operating conditions, and is shown with a broken black line with squares. The ninth waveform FFV_{H}T_{H} illustrates a fast device with high temperature and voltage operating conditions, and is shown with a broken grey line with diamonds.

As seen in FIG. 4, there is a non-uniformity among the different conditions. The below chart illustrates this non-uniformity by showing the variation in offset voltage at two bias current conditions.

| | **TTV_{T}T_{T}** | **SSV_{L}T_{L}** | **SSV_{L}T_{H}** | **SSV_{H}T_{L}** | **SSV_{H}T_{H}** | **FFV_{L}T_{L}** | **FFV_{L}T_{H}** | **FFV_{H}T_{L}** | **FFV_{H}T_{H}** |
|---|---|---|---|---|---|---|---|---|---|
| **ΔI/I=1** | -338 | -314 | -446 | -310 | -436 | -281 | -403 | -277 | -390 |
| **ΔI/I=-1** | 338 | 314 | 446 | 310 | 436 | 281 | 403 | 277 | 390 |

All values in mV.

As described above, the variation of the offset voltage in relation to PVT conditions results in a fluctuation of the detection level of a comparator. This is undesirable, and as such, aspects of the present invention provide for automatic calibration of the differential circuits to maintain a detection level of the comparator in the face of PVT variation. That is, embodiments of the present invention provide PVT tolerant differential circuits.

Referring back to FIG. 1, FIG. 1 illustrates a multi-level receiver 100 including a data slicer 120 having a replica stage comparator 130D. The replica stage comparator 130D enables the automatic calibration of the comparators' 130A, 130B, and 130C detection levels regardless of PVT variations.

According to an embodiment, the detection levels of the comparators 130A, 130B, and 130C are maintained by dynamically adjusting the bias current of each of the comparators' 130A, 130B, and 130C respective differential circuit. Adjusting the bias current of the respective differential circuits compensates for the PVT variations because the overdrive voltages of the input devices (and thus, the threshold levels of the comparators) are a function of their bias currents. Thus, by enforcing the right bias current to fix the overdrive voltage across PVT variations, each comparator's threshold level voltage is maintained.

In this regard, in an embodiment, the replica stage comparator 130D employs a replica stage differential circuit to automatically find the correct bias current for the present operating conditions, and enforce that bias current on the differential circuits of the first, second, and third comparators 103A, 130B, and 130C so that they maintain their appropriate threshold levels.

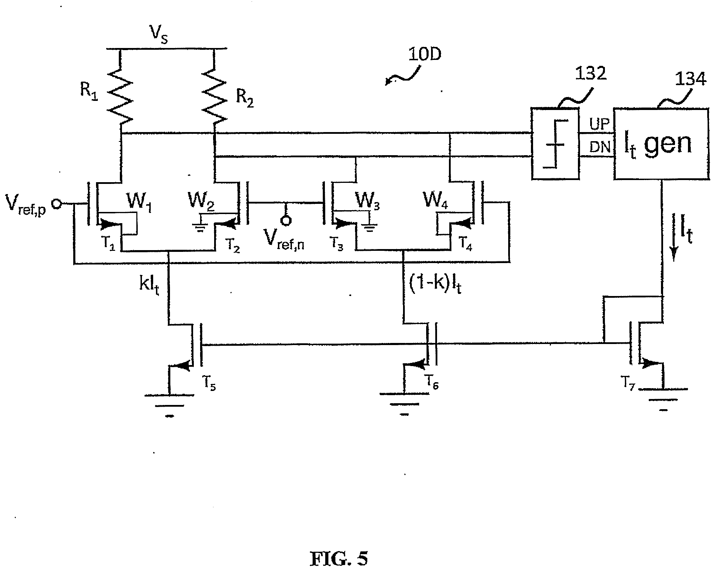

FIG. 5 illustrates a replica stage differential circuit according to an embodiment of the present invention.

In an embodiment, he replica stage differential circuit is a replica of a differential circuit that actually receives a data signal. For example, in an embodiment where the replica stage differential circuit is included in a data splitter of a multilevel receiver, the replica stage differential circuit is a replica of a differential circuit of a comparator that receives the multilevel signal.

For ease of explanation, the replica stage differential circuits described herein correspond to the mismatched differential circuit 10 illustrated in FIG. 2. However, a person of ordinary skill in the art would recognize that the scope of the present invention is not so limited.

FIG. 5 illustrates a replica stage differential amplifier 10D, which shares many similarities with the differential amplifier 10 described above. Accordingly, detailed descriptions of some of the components of the replica stage differential amplifier are given by way of reference to the above discussion of the differential amplifier 10.

The replica stage differential circuit 10D of FIG. 5 includes first through fourth transistors T₁ through T₄, where each transistor corresponds to one amplifier stage of one of two amplifier pairs. Here, the first transistor T₁ and the second transistor T₂ have their sources commonly coupled to a first current sink (or first tail device) and are respectively coupled to a voltage source Vₛ through resistors R₁ and R₂. The first and second transistors T₁ and T₂ correspond to the first differential amplifier pair. The third transistor T₃ and the fourth transistor T₄ similarly have their sources commonly coupled to a second current sink (or second tail device) and are respectively coupled to the voltage source Vₛ through resistors R₁ and R₂. The third and fourth transistors T₃ and T₄ correspond to the second differential amplifier pair.

The first and second differential amplifier pairs are coupled together to effectively operate as a single differential amplifier pair. That is, the first and second differential pairs collectively receive the same differential input signal and operate together to produce a single differential output signal (i.e., a positive and negative output signal).

The first current sink is provided by a fifth transistor T₅, which is set to sink a current kIₜ. The second current sink is provided by a sixth transistor T₆, which is set to sink a current (1-k)Iₜ. Here, k is corresponds to a property of the differential circuit. It is a parameter that represents the mismatch in bias current between the first and second current sinks.

The reference current Iₜ is generated by a current generator 134 and is output to a drain of the seventh transistor T₇. The drain of the seventh transistor T₇ is tied to its gate and to the gate of the fifth and sixth transistors T₅ and T₆. This copies the gate voltage of the seventh transistor T₇ to the gates of the fifth and sixth transistors T₅ and T₆, which effectively copies (or proportionally copies) the reference current Iₜ to the first and second current sinks (i.e., the current mirror circuit).

The reference current Iₜ is set as part of a feedback loop. The feedback loop automatically adjusts the reference current Iₜ in response to PVT variations.

In the present embodiment, the feedback loop includes a comparator 132 at the differential output of the differential circuit, which controls the setting of the current generator 134. As described, above, the current generator 134 sets the reference current Iₜ, which is copied to the first and second current sinks of the differential circuit, thus setting the bias current. Because the differential output of the differential circuit is a function of the bias current, setting the bias current closes the feedback loop.

As described above, the offset voltage of a differential circuit fluctuates in response to PVT variations. Accordingly, when a PVT change happens during operation, the fluctuation in offset voltage will result in a change in the differential output of the differential circuit. The comparator 132 will detect this change and control the current generator 134 to change the reference current Iₜ.

According to one embodiment, the replica differential circuit is configured to have an equilibrium where the differential output signal is at (or near) 0V. That is, where the two output nodes of the differential circuit are the same. Here, when the two output nodes are not the same, the comparator 132 will control the current generator 134 to increment or decrement the reference current Iₜ, until a new equilibrium is found.

According to one embodiment, the comparator 132 is a digital comparator and the current generator 134 is a digitally controlled current generator. Here, the comparator 132 sends a 1 or 0 to instruct the current generator 134 to increment or decrement the reference current Iₜ.

According to one embodiment, the feedback loop includes a hysteresis or delay circuit to avoid chatter.

In an embodiment, A differential reference signal V_{ref} (V_{ref,p} and V_{ref,n}) is applied to the input of the replica stage differential circuit 10D under a known operating condition. That is the differential reference signal i a constant reference signal, for example, the differential reference signal is set to the threshold level voltage of the replica differential circuit (e.g., a maximum achievable detection setting of the circuit).

As described above, the outputs V_{O+} V_{O-} of the replica stage differential circuit 10D may be received by the comparator 132 that controls the current generator 134 to generate a reference current Iₜ to force the outputs of the replica stage differential circuit to be at the same voltage for the given reference voltage at the differential input. The reference current Iₜ corresponds to the replica stage bias current. By copying the replica stage bias current to an input stage differential circuit of a comparator actually receiving an input signal, the input stage differential circuit is automatically calibrated in light of PVT variations. The bias current may be copied, for example, using a current mirror (with or without an amplifier to adjust for device differences) or by using a signal (e.g., a digital signal) to set signal controllable current sinks in the input stage differential circuit.

According to one embodiment, the properties of the replica differential circuit are set to their maximum (i.e., at one extreme or at a corner) where there may be the largest fluctuation in the output of the differential circuit due to PVT variations.

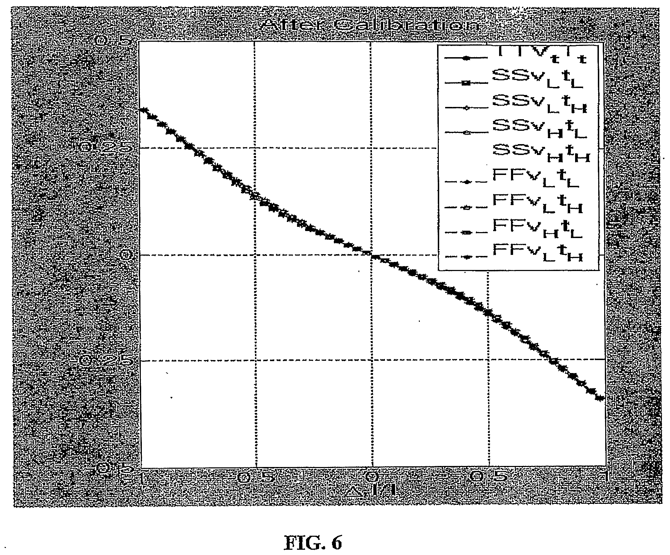

Referring now to FIG. 6, FIG 6 depicts a graph illustrating the resiliency against the impact of PVT variations on the offset voltage of a differential circuit device according to an embodiment of the present invention.

FIG. 6 illustrates nine (9) waveforms corresponding to the nine (9) waveforms shown above in FIG. 4. Accordingly, the descriptions of the waveforms are given by way of reference to the above-disclosure of FIG. 4. The waveforms of FIG. 6 differ from those of FIG. 4 in one significant aspect - they correspond to a calibrated differential circuit.

As evident by comparing the graphs of FIGS. 4 and 6, the impact that PVT variations have on the offset voltage of the calibrated differential circuit device is minimal. As seen in FIG. 6, there is a substantial uniformity among the different operating conditions. The below chart provides an example of this uniformity:

| | **TTV_{T}T_{T}** | **SSV_{L}T_{L}** | **SSV_{L}T_{H}** | **SSV_{H}T_{L}** | **SSV_{H}T_{H}** | **FFV_{L}T_{L}** | **FFV_{L}T_{H}** | **FFV_{H}T_{L}** | **FFV_{H}T_{H}** |
|---|---|---|---|---|---|---|---|---|---|
| **ΔI/I=1** | -338 | -338 | -339 | -339 | -338 | -337 | -338 | -339 | -338 |
| **ΔI/I=-1** | 338 | 338 | 339 | 339 | 338 | 337 | 338 | 339 | 338 |

According to aspects of the present invention, the replica stage comparator maintains the detection level of the input stage comparator under a variety of temperature and voltage conditions or under a variety of process corners. The above-described calibration together with a constant swing load keeps the threshold voltage, as well as an effective gain, of a differential circuit device constant across a PVT range. Calibration at a single detection level may be sufficient to guarantee tracking across all points because the threshold value may have a mild nonlinear dependence on the bias current.

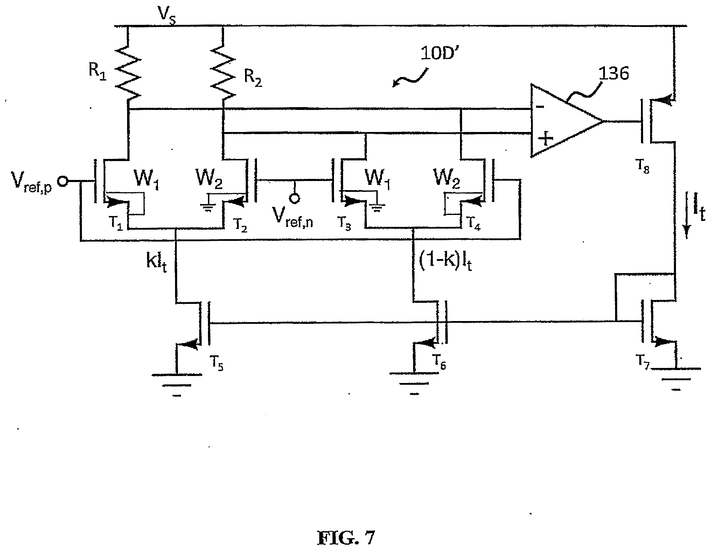

FIG. 7 illustrates a replica stage differential circuit according to another embodiment of the present invention.

The replica stage differential circuit 10D' of FIG. 7 shares some similar features and components with the replica stage differential circuit 10D of FIG. 5. Accordingly, detailed descriptions of some of the components of the replica stage differential amplifier are given by way of reference to the above discussion of the replica stage differential amplifier 10D.

In the replica stage differential circuit 10D' the reference current Iₜ is generated by a negative feedback controlled transistor. In the present embodiment, the feedback loop includes an amplifier 136 at the differential output of the differential circuit. An output of the amplifier 136 is connected to the gate of an eighth transistor T₈ (here a P-MOS transistor). The source of the eighth transistor T₈ is coupled to the voltage source V_{S}. The amplifier 136 controls the voltage at the gate of the eighth transistor T₈ to provide the reference current Iₜ, which is copied to the first and second current sinks of the replica differential circuit to set the bias current. Because the differential output of the differential circuit is a function of the bias current, setting the bias current closes the feedback loop.

As described above, the offset voltage of a differential circuit fluctuates in response to PVT variations. Accordingly, when a PVT change happens during operation, the fluctuation in offset voltage will result in a change in the differential output of the differential circuit. The amplifier 136 will detect this change and control the eighth transistor T₈ to change the reference current Iₜ.

According to one embodiment, the replica differential circuit is configured to have an equilibrium where the differential output signal is at (or near) 0V. That is, where the two output nodes of the differential circuit are the same. Here, when the two output nodes are not the same, the negative feedback circuit will adjust the reference current Iₜ, until a new equilibrium is found.

As described above the reference current Iₜ corresponds to the replica stage bias current. By copying the replica stage bias current to an input stage differential circuit of a comparator actually receiving an input signal, the input stage differential circuit is automatically calibrated in light of PVT variations.

The differential circuits according to embodiments of the present invention are formed of complementary metal oxide semiconductor (CMOS) devices. For example, as illustrated in FIG. 2, the mismatched differential circuits may be formed of N-MOS field effect transistors (FETs). As one of ordinary skill in the art would appreciate, however, the scope of the present invention applies to devices other than those explicitly described and illustrated in the present application. For example, differential circuits according to the present invention may be implemented using P-MOS FETs.

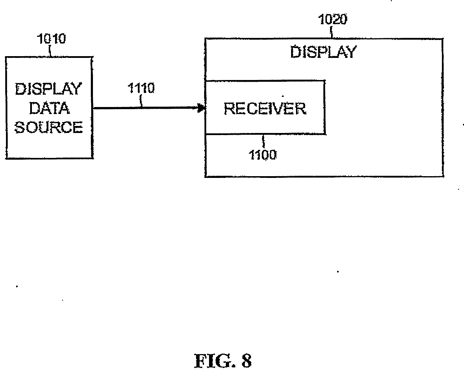

FIG. 8 illustrates an application of a receiver in a digital communication link for a display according to an embodiment of the present invention. In the present embodiment, a display data source 1010 transmits a display data signal over a transmission link 1110 to a display 1020. The display data signal includes information for displaying an image on the display. The display is, in an embodiment, an organic light emitting diode display, a liquid crystal display, or a plasma display.

The display 1020 includes a receiver 1100. In an embodiment, he receiver 1100 is implemented with the receiver circuit 100 described above in connection with FIGS. 1-8. That is, in an embodiment, the receiver 1100 is implemented using PVT tolerant differential circuits.

While aspects of the present invention have been illustrated and described in connection with certain embodiments, it is to be understood that the invention is not limited to the described embodiments.

For example, while some embodiments of the present invention were described in connection with a PAM-4 multilevel data system, embodiments of the 7292025-1-MHANDLEY present invention are not limited thereto. That is, the aspects and features of the present invention may be variously applied, such as in other pulse amplitude modulation systems (e.g., PAM-5, -6, -7, etc.), in digital-to-analog converters, peak-detectors, or any other application that mismatched differential circuits may be used.

As a further example, although various embodiments of the present invention utilize a triple-mismatched amplifier/triple-mismatched differential circuits, other embodiments of the present invention use different circuits to accomplish the discussed aspects of the invention. For example, other embodiments of the present invention use a double-mismatched amplifier that allows for construction of the discussed feedback loop/feedback circuit.

## Claims

1. An automatically calibrated differential amplifier in response to process or environmental variations for use as a comparator in a multilevel signal receiver, comprising:
an input stage differential amplifier (130A, 130B, 130C) configured to receive an input differential signal, to differentially amplify the input differential signal to generate an input stage output differential signal, and to have an input stage bias current; and
a replica stage differential amplifier (130D) comprising:
a first amplifier leg; and
a second amplifier leg;
wherein the first and second amplifier legs, together, are configured to receive a reference differential signal (V_{ref,p}, V_{ref,n}), wherein the reference differential signal is a signal which provides a known output signal at an output of the replica stage differential amplifier under known operating conditions, and differentially amplify the reference differential signal to provide a replica stage output differential signal; and
a feedback circuit configured to:
receive a differential output of the replica stage differential amplifier;
to adjust bias currents of the replica stage in order to maintain a required output in response to the reference differential signal;
output a reference current (It) based on the replica stage output differential signal; and
copy the reference current to the input stage differential amplifier to enable automatic calibration,
wherein a sum of a first amplifier leg current of the first amplifier leg and a second amplifier leg current of the second amplifier leg equals the replica stage bias current and wherein the replica stage bias current and the input stage bias current are based on the reference current.

2. An automatically calibrated differential amplifier according to claim 1,
wherein the feedback circuit comprises a comparator (132) and a current generator (134), and
wherein the comparator is configured to receive the replica stage output differential signal and to control the current generator to increment or decrement the reference current (It) according to the replica stage output differential signal.

3. An automatically calibrated differential amplifier according to claim 1,
wherein the feedback circuit comprises an amplifier (136) and a transistor (T₈), the transistor being configured to output the reference current (It), and
wherein the amplifier is configured to receive the replica stage output differential signal and to control a gate voltage of the transistor according to the replica stage output differential signal to adjust the reference current.

4. An automatically calibrated differential amplifier according to any preceding claim,
wherein the replica stage differential amplifier further comprises:
a first resistor (R1) having a first terminal coupled to a voltage source (Vs), and a second terminal;
a second resistor (R2) having a first terminal coupled to the voltage source, and a second terminal;
a first current sink configured to sink the first amplifier leg current; and
a second current sink configured to sink the second amplifier leg current;
wherein the first amplifier leg comprises:
a first transistor (T1) having a first terminal coupled to the second terminal of the first resistor, a second terminal coupled to the first current sink, and a gate terminal configured to receive a first reference signal (V_{ref,p}) of the reference differential signal; and
a second transistor (T2) having a first terminal coupled to the second terminal of the second resistor, a second terminal coupled to the first current sink, and a gate terminal configured to receive a second reference signal (V_{ref,n}) of the reference differential signal;
wherein the second amplifier leg comprises:
a third transistor (T3) having a first terminal coupled to the second terminal of the second resistor, a second terminal coupled to the second current sink, and a gate terminal configured to receive the second reference signal (V_{ref,n}) of the reference differential signal; and
a fourth transistor (T4) having a first terminal coupled to the second terminal of the first resistor, a second terminal coupled to the second current sink, and a gate terminal configured to receive the first reference signal (V_{ref,p}) of the reference differential signal; and
wherein the feedback circuit is configured to receive the replica stage output differential signal from the first terminal of the first transistor (T1) and the first terminal of the second transistor (T2), and to output the reference current (It),
wherein the first amplifier leg current and the second amplifier leg current are based on the reference current (It).

5. An automatically calibrated differential amplifier according to any preceding claim, further comprising a current mirror coupled to the input stage differential amplifier and the replica stage differential amplifier,
wherein the current mirror copies the reference current (It) to control the input stage bias current.

6. An automatically calibrated differential amplifier according to any preceding claim,
wherein the input stage differential amplifier (130A, 130B, 130C) comprises a first amplifier leg comprising a first transistor and a second amplifier leg comprising a second transistor, and is configured to be at an input stage of a comparator,
wherein the first and second amplifier legs of the input stage differential amplifier, together, are configured to differentially amplify the input differential signal,
wherein the input stage differential amplifier is configured to have an input offset voltage, and
wherein the input offset voltage corresponds to a difference between a bulk potential of the first transistor and a bulk potential of the second transistor.

7. A multilevel signal receiver comprising:
an input terminal configured to receive a multilevel differential signal;
a data slicer (120) coupled to the input terminal and configured to determine voltage levels of the multilevel differential signal, the data slicer comprising an automatically calibrated differential amplifier according to any preceding claim having a plurality of input stage differential amplifiers (130A, 130B, 130C); and
a decoder (140) coupled to an output of the data slicer (120) and configured to decode bits of the multilevel differential signal,
wherein each of the input stage differential amplifiers comprises:
a first amplifier leg; and
a second amplifier leg,
wherein the first amplifier leg and the second amplifier leg, together, are configured to differentially amplify the multilevel differential signal to provide a threshold determination signal,
wherein the input stage differential amplifier is configured to have an input offset voltage, and
wherein each of the input stage differential amplifiers is configured to have a threshold level different from the threshold level of other ones of the input stage differential amplifiers,
wherein each of the input stage differential amplifiers is configured to output its threshold determination signal to the decoder (140) to indicate whether or not the multilevel signal is greater than its threshold level,
wherein, for each of the input stage differential amplifiers, the threshold level corresponds to the input offset voltage of the input stage differential amplifier.

8. A multilevel signal receiver according to claim 7 when dependent on claim 5,
wherein the current mirror copies the reference current to control the input stage bias current of the input stage differential amplifier of each of the input stage differential amplifiers.

## Patentansprüche

1. Als Reaktion auf Prozess- oder Umweltschwankungen automatisch kalibrierter Differenzialverstärker zur Verwendung als Komparator in einem mehrpegeligen Signalempfänger, umfassend:
einen Eingangsstufen-Differenzialverstärker (130A, 130B, 130C), der dazu konfiguriert ist, ein Eingangsdifferenzialsignal zu empfangen, das Eingangsdifferenzialsignal differentiell zu verstärken, um ein Eingangsstufen-Ausgangsdifferenzialsignal zu erzeugen, und einen Eingangsstufen-Vorstrom aufzuweisen; und
einen Replikationsstufen-Differenzialverstärker (130D), umfassend:
einen ersten Verstärkerzweig; und
einen zweiten Verstärkerzweig;
wobei der erste und der zweite Verstärkerzweig gemeinsam dazu konfiguriert sind, ein Referenz-Differenzialsignal (V_{ref,p}, V_{ref,n}) zu empfangen, wobei das Referenz-Differenzialsignal ein Signal ist, das unter bekannten Betriebsbedingungen an einem Ausgang des Replikationsstufen-Differenzialverstärkers ein bekanntes Ausgangssignal bereitstellt, und das Referenz-Differenzialsignal differentiell zu verstärken, um ein Replikationsstufen-Ausgangsdifferenzialsignal bereitzustellen; und
eine Rückkopplungsschaltung, die konfiguriert ist zum:
Empfangen einer Differenzial-Ausgabe des Replikationsstufen-Differenzialverstärkers;
Anpassen von Vorströmen der Replikationsstufe, um als Reaktion auf das Referenz-Differenzialsignal eine benötigte Ausgabe aufrechtzuerhalten;
Ausgeben eines Referenzstroms (It) auf der Grundlage des Replikationsstufen-Ausgangsdifferenzialsignals; und
Kopieren des Referenzstroms auf den Eingangsstufen-Differenzialverstärker, um automatisches Kalibrieren zu ermöglichen,
wobei eine Summe eines ersten Verstärkerzweigstroms des ersten Verstärkerzweigs und eines zweiten Verstärkerzweigstroms des zweiten Verstärkerzweigs gleich dem Replikationsstufen-Vorstrom ist und wobei der Replikationsstufen-Vorstrom und der Eingangsstufen-Vorstrom auf dem Referenzstrom basieren.

2. Automatisch kalibrierter Differenzialverstärker nach Anspruch 1,
wobei die Rückkopplungsschaltung einen Komparator (132) und einen Stromgenerator (134) umfasst und
wobei der Komparator dazu konfiguriert ist, das Replikationsstufen-Ausgangsdifferenzialsignal zu empfangen und den Stromgenerator so zu steuern, dass er den Referenzstrom (It) entsprechend dem Replikationsstufen-Ausgangsdifferenzialsignal erhöht oder verringert.

3. Automatisch kalibrierter Differenzialverstärker nach Anspruch 1,
wobei die Rückkopplungsschaltung einen Verstärker (136) und einen Transistor (T₈) umfasst, wobei der Transistor dazu konfiguriert ist, den Referenzstrom (It) auszugeben, und
wobei der Verstärker dazu konfiguriert ist, das Replikationsstufen-Ausgangsdifferenzialsignal zu empfangen und eine Gate-Spannung des Transistors entsprechend dem Replikationsstufen-Ausgangsdifferenzialsignal so zu steuern, dass der Referenzstrom angepasst wird.

4. Automatisch kalibrierter Differenzialverstärker nach einem der vorangehenden Ansprüche, wobei der Replikationsstufen-Differenzialverstärker ferner umfasst:
einen ersten Widerstand (R1), der eine erste Klemme, die an eine Spannungsquelle (Vs) gekoppelt ist, und eine zweite Klemme aufweist;
einen zweiten Widerstand (R2), der eine erste Klemme, die an die Spannungsquelle gekoppelt ist, und eine zweite Klemme aufweist;
eine erste Stromsenke, die zum Aufnehmen des ersten Verstärkerzweigstroms konfiguriert ist; und
eine zweite Stromsenke, die zum Aufnehmen des zweiten Verstärkerzweigstroms konfiguriert ist;
wobei der erste Verstärkerzweig umfasst:
einen ersten Transistor (T1), der eine erste Klemme, die an die zweite Klemme des ersten Widerstands gekoppelt ist, eine zweite Klemme, die an die erste Stromsenke gekoppelt ist, und eine Gate-Klemme, die zum Empfangen eines ersten Referenzsignals (V_{ref,p}) des Referenz-Differenzialsignals konfiguriert ist, aufweist; und
einen zweiten Transistor (T2), der eine erste Klemme, die an die zweite Klemme des zweiten Widerstands gekoppelt ist, eine zweite Klemme, die an die erste Stromsenke gekoppelt ist, und eine Gate-Klemme, die zum Empfangen eines zweiten Referenzsignals (V_{ref,n}) des Referenz-Differenzialsignals konfiguriert ist, aufweist;
wobei der zweite Verstärkerzweig umfasst:
einen dritten Transistor (T3), der eine erste Klemme, die an die zweite Klemme des zweiten Widerstands gekoppelt ist, eine zweite Klemme, die an die zweite Stromsenke gekoppelt ist, und eine Gate-Klemme, die zum Empfangen des zweiten Referenzsignals (V_{ref,n}) des Referenz-Differenzialsignals konfiguriert ist, aufweist; und
einen vierten Transistor (T4), der eine erste Klemme, die an die zweite Klemme des ersten Widerstands gekoppelt ist, eine zweite Klemme, die an die zweite Stromsenke gekoppelt ist, und eine Gate-Klemme, die zum Empfangen des ersten Referenzsignals (V_{ref,p}) des Referenz-Differenzialsignals konfiguriert ist, aufweist; und
wobei die Rückkopplungsschaltung dazu konfiguriert ist, das Replikationsstufen-Ausgangsdifferenzialsignal von der ersten Klemme des ersten Transistors (T1) und der ersten Klemme des zweiten Transistors (T2) zu empfangen und den Referenzstrom (It) auszugeben,
wobei der erste Verstärkerzweigstrom und der zweite Verstärkerzweigstrom auf dem Referenzstrom (It) basieren.

5. Automatisch kalibrierter Differenzialverstärker nach einem der vorangehenden Ansprüche, ferner umfassend einen Stromspiegel, der an den Eingangsstufen-Differenzialverstärker und den Replikationsstufen-Differenzialverstärker gekoppelt ist,
wobei der Stromspiegel den Referenzstrom (It) kopiert, um den Eingangsstufen-Vorstrom zu steuern.

6. Automatisch kalibrierter Differenzialverstärker nach einem der vorangehenden Ansprüche,
wobei der Eingangsstufen-Differenzialverstärker (130A, 130B, 130C) einen ersten Verstärkerzweig, umfassend einen ersten Transistor, und einen zweiten Verstärkerzweig, umfassend einen zweiten Transistor, umfasst und dazu konfiguriert ist, sich an einer Eingangsstufe eines Komparators zu befinden,
wobei der erste und der zweite Verstärkerzweig des Eingangsstufen-Differenzialverstärkers gemeinsam dazu konfiguriert sind, das Eingangsdifferenzialsignal differentiell zu verstärken,
wobei der Eingangsstufen-Differenzialverstärker dazu konfiguriert ist, eine Eingangs-Offsetspannung aufzuweisen, und
wobei die Eingangs-Offsetspannung einer Differenz zwischen einem Massenpotenzial des ersten Transistors und einem Massenpotenzial des zweiten Transistors entspricht.

7. Mehrpegeliger Signalempfänger, umfassend:
eine Eingangsklemme, die dazu konfiguriert ist, ein mehrpegeliges Differenzialsignal zu empfangen;
einen Datentrenner (120), der an die Eingangsklemme gekoppelt und dazu konfiguriert ist, Spannungspegel des mehrpegeligen Differenzialsignals zu bestimmen, wobei der Datentrenner einen automatisch kalibrierten Differenzialverstärker nach einem der vorangehenden Ansprüche umfasst, der eine Mehrzahl von Eingangsstufen-Differenzialverstärkern (130A, 130B, 130C) aufweist; und
einen Decoder (140), der an einen Ausgang des Datentrenners (120) gekoppelt und dazu konfiguriert ist, Bits des mehrpegeligen Differenzialsignals zu decodieren,
wobei jeder der Eingangsstufen-Differenzialverstärker umfasst:
einen ersten Verstärkerzweig; und
einen zweiten Verstärkerzweig,
wobei der erste und der zweite Verstärkerzweig gemeinsam dazu konfiguriert sind, das mehrpegelige Differenzialsignal differentiell zu verstärken, um ein Schwellenwertbestimmungssignal bereitzustellen,
wobei der Eingangsstufen-Differenzialverstärker dazu konfiguriert ist, eine Eingangs-Offsetspannung aufzuweisen, und
wobei jeder der Eingangsstufen-Differenzialverstärker dazu konfiguriert ist, einen Pegelschwellenwert aufzuweisen, der sich von den Pegelschwellenwerten anderer Eingangsstufen-Differenzialverstärker unterscheidet,
wobei jeder der Eingangsstufen-Differenzialverstärker dazu konfiguriert ist, sein Schwellenwertbestimmungssignal an den Decoder (140) auszugeben, um dadurch anzugeben, ob das mehrpegelige Signal über seinem Pegelschwellenwert liegt oder nicht,
wobei der Pegelschwellenwert für jeden der Eingangsstufen-Differenzialverstärker der Eingangs-Offsetspannung des Eingangsstufen-Differenzialverstärkers entspricht.

8. Mehrpegeliger Signalempfänger nach Anspruch 7, soweit abhängig von Anspruch 5,
wobei der Stromspiegel den Referenzstrom kopiert, um den Eingangsstufen-Vorstrom von jedem der Eingangsstufen-Differenzialverstärker zu steuern.

## Revendications

1. Amplificateur différentiel étalonné automatiquement en réponse à des variations de traitement ou environnementales pour l'utilisation comme comparateur dans un récepteur de signaux à niveaux multiples, comprenant :
un amplificateur différentiel d'étage d'entrée (130A, 130B, 130C) configuré pour recevoir un signal différentiel d'entrée, amplifier de façon différentielle le signal différentiel d'entrée de façon à générer un signal différentiel de sortie d'étage d'entrée, et avoir un courant de polarisation d'étage d'entrée ; et
un amplificateur différentiel d'étage de réplique (130D), comprenant :
une première branche d'amplificateur ; et
une deuxième branche d'amplificateur ;
dans lequel les première et deuxième branches d'amplificateur, ensemble, sont configurées pour recevoir un signal différentiel de référence (V_{ref,p}, V_{ref,n}), le signal différentiel de référence étant un signal qui produit un signal de sortie connu sur une sortie de l'amplificateur différentiel d'étage de réplique sous des conditions de fonctionnement connues, et pour amplifier de façon différentielle le signal différentiel de référence de façon à produire un signal différentiel de sortie d'étage de réplique ; et
un circuit de rétroaction configuré pour :
recevoir une sortie différentielle de l'amplificateur différentiel de l'étage de réplique ;
ajuster des courants de polarisation de l'étage de réplique de façon à maintenir une sortie requise en réponse au signal différentiel de référence ;
délivrer en sortie un courant de référence (It) en fonction du signal différentiel de sortie d'étage de réplique ; et
copier le courant de référence dans l'amplificateur différentiel d'étage d'entrée de façon à permettre un étalonnage automatique,
dans lequel une somme d'un courant de première branche d'amplificateur de la première branche d'amplificateur et d'un courant de deuxième branche d'amplificateur de la deuxième branche d'amplificateur est égal au courant de polarisation d'étage de répligue, et dans lequel le courant de polarisation d'étage de réplique et le courant de polarisation d'étage d'entrée sont fonction du courant de référence.

2. Amplificateur différentiel étalonné automatiquement selon la revendication 1,
dans lequel le circuit de rétroaction comprend un comparateur (132) et un générateur de courant (134), et
dans lequel le comparateur est configuré pour recevoir le signal différentiel de sortie d'étage de réplique et commander le générateur de courant de façon à incrémenter ou à décrémenter le courant de référence (It) en fonction du signal différentiel de sortie d'étage de réplique.

3. Amplificateur différentiel étalonné automatiquement selon la revendication 1,
dans lequel le circuit de rétroaction comprend un amplificateur (136) et un transistor (T₈), le transistor étant configuré pour délivrer en sortie le courant de référence (It), et
dans lequel l'amplificateur est configuré pour recevoir le signal différentiel de sortie d'étage de réplique et commander une tension de grille du transistor en fonction du signal différentiel de sortie d'étage de réplique de façon à ajuster le courant de référence.

4. Amplificateur différentiel étalonné automatiquement selon l'une quelconque des revendications précédentes,
dans lequel l'amplificateur différentiel d'étage de réplique comprend de plus :
une première résistance (R1) comportant une première borne couplée à une source de tension (Vs), et une deuxième borne ;
une deuxième résistance (R2) comportant une première borne couplée à la source de tension, et une deuxième borne ;
un premier puit de courant configuré pour dissiper le courant de première branche d'amplificateur ; et
un deuxième puit de courant configuré pour dissiper le courant de deuxième branche d'amplificateur ;
dans lequel la première branche d'amplificateur comprend :
un premier transistor (T1) comportant une première borne couplée à la deuxième borne de la première résistance, une deuxième borne couplée au premier puit de courant, et une borne de grille configurée pour recevoir un premier signal de référence (V_{ref,p}) du signal différentiel de référence ; et
un deuxième transistor (T2) comportant une première borne couplée à la deuxième borne de la deuxième résistance, une deuxième borne couplée au premier puit de courant, et une borne de grille configurée pour recevoir un deuxième signal de référence (V_{ref,n}) du signal différentiel de référence ;
dans lequel la deuxième branche d'amplificateur comprend :
un troisième transistor (T3) comportant une première borne couplée à la deuxième borne de la deuxième résistance, une deuxième borne couplée au deuxième puit de courant, et une borne de grille configurée pour recevoir le deuxième signal de référence (V_{ref,n}) du signal différentiel de référence ; et
un quatrième transistor (T4) comportant une première borne couplée à la deuxième borne de la première résistance, une deuxième borne couplée au deuxième puit de courant, et une borne de grille configurée pour recevoir le premier signal de référence (V_{ref,p}) du signal différentiel de référence ; et
dans lequel le circuit de rétroaction est configuré pour recevoir le signal différentiel de sortie d'étage de réplique à partir de la première borne du premier transistor (T1) et de la première borne du deuxième transistor (T2), et pour délivrer en sortie le courant de référence (It),
dans lequel le courant de première branche d'amplificateur et le courant de deuxième branche d'amplificateur sont fonction du courant de référence (It).

5. Amplificateur différentiel étalonné automatiquement selon l'une quelconque des revendications précédentes, comprenant de plus un miroir de courant couplé à l'amplificateur différentiel d'étage d'entrée et à l'amplificateur différentiel d'étage de réplique,
dans lequel le miroir de courant copie le courant de référence (It) pour commander le courant de polarisation d'étage d'entrée.

6. Amplificateur différentiel étalonné automatiquement selon l'une quelconque des revendications précédentes,
dans lequel l'amplificateur différentiel d'étage d'entrée (130A, 130B, 130C) comprend une première branche d'amplificateur comprenant un premier transistor et une deuxième branche d'amplificateur comprenant un deuxième transistor, et est configuré pour se trouver à un étage d'entrée d'un comparateur,
dans lequel les première et deuxième branches d'amplificateur de l'amplificateur différentiel d'étage d'entrée, ensemble, sont configurées pour amplifier de façon différentielle le signal différentiel d'entrée ;
dans lequel l'amplificateur différentiel d'étage d'entrée est configuré pour avoir une tension de décalage d'entrée, et
dans lequel la tension de décalage d'entrée correspond à une différence entre un potentiel de corps du premier transistor et un potentiel de corps du deuxième transistor.

7. Récepteur de signaux à niveaux multiples, comprenant :
une borne d'entrée configurée pour recevoir un signal différentiel à niveaux multiples ;
un dispositif de découpage de données (120) couplé à la borne d'entrée et configuré pour déterminer des niveaux de tension du signal différentiel à niveaux multiples, le dispositif de découpage de données comprenant un amplificateur différentiel étalonné automatiquement selon l'une quelconque des revendications précédentes, comportant une pluralité d'amplificateurs différentiels d'étage d'entrée (130A, 130B, 130C) ; et
un décodeur (140) couplé à une sortie du dispositif de découpage de données (120), et configuré pour décoder des bits du signal différentiel à niveaux multiples,
dans lequel chacun des amplificateurs différentiels d'étage d'entrée comprend :
une première branche d'amplificateur ; et
une deuxième branche d'amplificateur,
dans lequel la première branche d'amplificateur et la deuxième branche d'amplificateur, ensemble, sont configurées pour amplifier de façon différentielle le signal différentiel à niveaux multiples de façon à produire un signal de détermination de seuil,
dans lequel l'amplificateur différentiel d'étage d'entrée est configuré pour avoir une tension de décalage d'entrée, et
dans lequel chacun des amplificateurs différentiels d'étage d'entrée est configuré pour avoir un niveau de seuil différent du niveau de seuil d'autres des amplificateurs différentiels d'étage d'entrée,
dans lequel chacun des amplificateurs différentiels d'étage d'entrée est configuré pour délivrer en sortie son signal de détermination de seuil au décodeur (140) de façon à indiquer si oui ou non le signal à niveaux multiples est supérieur à son niveau de seuil,
dans lequel, pour chacun des amplificateurs différentiels d'étage d'entrée, le niveau de seuil correspond à la tension de décalage d'entrée de l'amplificateur différentiel d'étage d'entrée.

8. Récepteur de signaux à niveaux multiples selon la revendication 7 lorsqu'elle dépend de la revendication 5,
dans lequel le miroir de courant copie le courant de référence de façon à commander le courant de polarisation d'étage d'entrée de l'amplificateur différentiel d'étage d'entrée de chacun des amplificateurs différentiels d'étage d'entrée.
